Europäisches Patentamt

(19) European Patent Office

Office européen des brevets

(11) Numéro de publication: **0 1 1 5 6 5 0**
**B1**

(12) **FASCICULE DE BREVET EUROPEEN**

(45) Date de publication du fascicule du brevet:
**30.03.88**

(51) Int. Cl.⁴: **H 01 L 29/08,** H 01 L 29/78

(21) Numéro de dépôt: **83201700.8**

(22) Date de dépôt: **01.12.83**

(54) **Dispositif MOS FET de puissance à structure plane multicellulaire.**

(30) Priorité: **08.12.82 FR 8220554**

(43) Date de publication de la demande:
**15.08.84 Bulletin 84/33**

(45) Mention de la délivrance du brevet:
**30.03.88 Bulletin 88/13**

(84) Etats contractants désignés:
**DE FR GB NL**

(56) Documents cités:
**EP - A - 0 101 120**
**US - A - 4 148 047**

**INTERNATIONAL ELECTRON DEVICES MEETING, 8-10 décembre 1980, Washington, D.C., pages 91-94, IEEE, New York, US, J.MENA et al.:"High frequency performance of VDMOS power transistors"**

(73) Titulaire: **RTC-COMPELEC, 130, Avenue Ledru-Rollin, F-75011 Paris (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB NL**

(72) Inventeur: **Nguyen Minh, Chau, Société Civile S.P.I.D. 209 rue de l'Université, F-75007 Paris (FR)**
Inventeur: **Vertongen, Bernard, Société Civile S.P.I.D. 209 rue de l'Université, F-75007 Paris (FR)**

(74) Mandataire: **Pinchon, Pierre et al, Société Civile S.P.I.D. 209 rue de l'Université, F-75007 Paris (FR)**

## Description

La présente invention concerne un dispositif de type MOS FET vertical à structure plane multicellulaire réalisé dans un cristal semiconducteur et comportant un ensemble de cellules élémentaires identiques de forme polygonale simple au centre de chacune desquelles est située une région dite de court-circuit N+P+, chaque cellule étant obtenue, en premier lieu, par une diffusion dans une couche d'un premier type de conduction constituant la zone de drain du dispositif d'un premier îlot fortement dopé d'impuretés d'un second type de conduction opposé au premier définissant, entre autres, à la surface de ladite couche le contour de ladite zone de drain et la forme de ladite cellule, puis, en second lieu, par une diffusion dans ledit premier îlot d'un second îlot localisé fortement dopé d'impuretés du premier type de conduction constituant la zone de source et qui délimite, d'une part une zone superficielle dite de canal séparant ledit second îlot de la couche du premier type de conduction, et d'autre part la région centrale de court-circuit.

On sait que, dans la réalisation de dispositifs MOS FET de puissance, la solution la plus utilisée dorénavant consiste à utiliser une structure plane dite multicellulaire constituée d'un agencement en parallèle, dans un cristal semiconducteur, d'un certain nombre de cellules élémentaires juxtaposées et de forme géométrique simple.

La publication: «International Electron Devices Meeting, 8–10 décembre 1980. Washington D.C. pages 91–94, IEEE, New York, US», par un article de J. Mena et al., mentionne l'utilisation de structures à cellules élémentaires hexagonales ou carrées.

Ces structures sont caractérisées par une zone de drain, par une zone de source et par une zone de canal, et sont définies d'une part par un coefficient de remplissage qui correspond au rapport:

$$\frac{P}{S} = \frac{\text{périmètre du canal}}{\text{surface du cristal semi-conducteur}}$$

et d'autre part par la valeur de leur résistance directe $R_{ON}$ à l'état passant. Pour une configuration donnée et dans des structures fonctionnant à des tensions relativement basses, la résistance $R_{ON}$ est essentiellement due à la résistance transversale de canal dont la valeur est inversement proportionnelle au périmètre dudit canal, d'où l'intérêt d'améliorer ledit coefficient de remplissage $\frac{P}{S}$.

L'étude de ce dernier a permis de constater que, dans chacun des cas, il existe une dimension optimale du côté du motif de source inclus dans chaque cellule élémentaire pour laquelle le rapport P/S est maximum, ce maximum étant constant et théoriquement égal à $\frac{1}{d}$ (d représentant en µm la distance séparant deux zones de source contiguës, distance définie en réalité par les tolérances de photogravure acceptables dans la réalisation des cellules).

L'étude dudit coefficient de remplissage effectuée pour les diverses géométries a également permis de constater que, à P/S égal, la densité de cellules est plus faible pour une structure formée de cellules triangulaires. Cependant, dans cette structure comme dans les autres, le coefficient de remplissage reste inférieur à la valeur espérée théoriquement. Ceci est donc dû notamment au fait que les tolérances de photogravures nécessaires à la mise en place dans et sur le cristal semi-conducteur des divers éléments de chaque cellule conduisent soit à augmenter la surface des cellules élémentaires par rapport à la zone de source, soit à réduire ladite zone de source par rapport à celle de la cellule élémentaire, ces deux solutions revenant en fait à allonger la distance d séparant deux zones de source et à diminuer le périmètre de canal.

Cette réduction de la valeur du coefficient de remplissage par rapport à sa valeur théorique est également due au fait que, dans les structures actuelles et pour fixer le potentiel de la zone d'inversion, on crée dans chaque cellule élémentaire une région de court-circuit N+P+ obtenue en réalisant un îlot de type P+ au centre de la région N+ formant la zone de source, cet îlot central ayant généralement une forme homothétique à celle de ladite cellule élémentaire.

La présente invention a pour but de remédier à ces inconvénients. Pour ce faire, la Demanderesse s'appuie sur une étude faite concernant la densité des cellules élémentaires dans une surface donnée en fonction de la forme desdites cellules.

La présente invention concerne donc un dispositif de type MOS FET vertical à structure plane multicellulaire réalisé dans un cristal semiconducteur et comportant un ensemble de cellules élémentaires identiques de forme polygonale simple, régulièrement distribuées à la surface du dispositif, cellules élémentaires au centre de chacune desquelles est située une région dite de court-circuit N+/P+, chaque cellule étant constituée dans une couche d'un premier type de conduction constituant la zone de drain du dispositif, d'un premier îlot fortement dopé d'impuretés d'un second type de conduction opposé au premier définissant, entre autres, à la surface de ladite couche, le contour de ladite zone de drain et la forme de ladite cellule et, dans ledit premier îlot, d'un second îlot localisé fortement dopé d'impuretés du premier type de conduction constituant la zone de source et qui délimite, d'une part une zone superficielle dite de canal séparant ledit second îlot de la couche du premier type de conduction, et d'autre part la région centrale de court-circuit, dispositif caractérisé en ce que les cellules élémentaires sont triangulaires, et que dans le volume des zones de drain laissé libre entre six sommets adjacents appartenant à six cellules élémentaires voisines, sont disposés des éléments additionnels de même structure et de même fonction que lesdites cellules élémentaires et ayant une forme hexagonale.

Les éléments additionnels créés entre les cellules élémentaires s'ajoutent à celles-ci pour augmenter le périmètre de canal et, par conséquent, pour améliorer le rapport P/S qui se rapproche ainsi très notablement des valeurs maximales théoriques.

En utilisant une géométrie triangulaire pour les cellules élémentaires et une géométrie hexagonale pour ce qui concerne les éléments additionnels, une telle association permet d'augmenter ledit coefficient P/S dans des proportions pouvant atteindre au plus 30% dans les conditions optimales où la valeur du diamètre du cercle inscrit dans l'élément hexagonal complémentaire est égale à la distance séparant les zones de source de deux cellules élémentaires triangulaires contiguës.

Dans une première forme de réalisation, les éléments additionnels sont disposés de manière telle que leurs sommets se trouvent en regard des sommets des cellules élémentaires.

Dans une seconde forme de réalisation, les éléments additionnels sont disposés de manière telle que leurs côtés se trouvent en regard des sommets des cellules élémentaires.

Cette forme de réalisation, particulièrement avantageuse, a pour effet d'abaisser le champ électrique maximal produit en regard du sommet de chacun des triangles.

La description qui va suivre, en regard des figures décrivant des exemples non limitatifs, fera bien comprendre comment l'invention peut être réalisée.

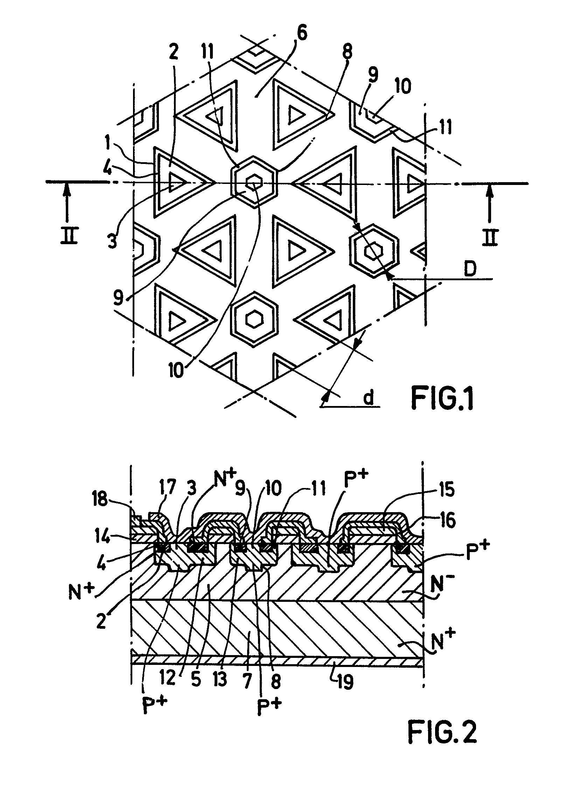

La figure 1 représente une vue de dessus d'une portion d'un dispositif conforme à l'invention dans la forme de réalisation préférentielle selon laquelle des cellules élémentaires triangulaires sont associées à des éléments complémentaires hexagonaux.

La figure 1 illustre la coupe schématique suivant la ligne II–II de ladite portion de dispositif.

Il est à noter que, sur les figures, les dimensions sont considérablement exagérées et peu proportionnées, ceci afin de rendre les dessins plus clairs.

Par ailleurs, la vue de dessus est représentée sans tenir compte des couches isolantes d'oxyde et des plages de prise de contact de manière à faire mieux comprendre l'invention.

Conformément à ladite invention et selon les figures 1 et 2, une cellule élémentaire 1 de forme triangulaire comporte en surface une région 2 de type N+ constituant la zone de source d'un transistor MOS créée dans un îlot de type P+ duquel apparaissent, d'une part la région de court-circuit 3, et d'autre part la zone de canal 4.

La forme dudit îlot de type P+ diffusé dans une couche 5 de type N− définit une pluralité de bandes superficielles 6 qui, avec le reliquat de ladite couche 5 et avec le substrat 7 qui la porte, constituent la zone de drain du transistor MOS.

Dans la pratique, cette cellule est reproduite en multiples exemplaires ainsi que le montrent les figures 1 et 2. Dans leur regroupement, les cellules élémentaires laissent apparaître entre elles des espaces assez larges dans lesquels, conformément à l'invention, sont disposés les éléments additionnels 8. Ces éléments additionnels 8 présentent la même structure que les cellules élémentaires 1 et comportent donc une zone de source 9 délimitant une région de court-circuit 10 et une zone de canal 11.

Pour obtenir cet ensemble de cellules élémentaires et d'éléments additionnels, on part du substrat semi-conducteur 7, en silicium par exemple et de préférence de type N+, sur lequel on dépose par épitaxie une couche 5 de même type de conduction, mais à faible concentration d'impuretés donc N−.

Dans une forme préférentielle de mise en œuvre, après une photogravure appropriée de la couche d'oxyde recouvrant la surface de ladite couche 5, on diffuse les îlots profonds 3 et 10 d'un second type de conduction opposé au premier et à forte concentration d'impuretés de dopage, donc P+; à travers de nouvelles ouvertures pratiquées dans cette même couche d'oxyde, on diffuse ensuite successivement les îlots 12 et 13 de type P+, moins profonds que les îlots 3 et 10, et, à l'intérieur de ces îlots 12 et 13, les nouveaux îlots 2 et 9 de type N+. La diffusion latérale desdits îlots 12, 13 et 2, 9 délimite les régions dites de court-circuit 3 et 10 et les zones de canal 4 et 11.

La forme donnée aux masques de photogravure des îlots 12, 13, 2, 9 détermine également la disposition de la zone de drain.

Le fait de créer à l'aplomb de la région de court-circuit des îlots 3, 10 plus profonds que l'ensemble des îlots 12, 13 a pour but d'améliorer la tenue en tension du dispositif par réduction du rayon de courbure de la jonction.

Pour obtenir ce résultat, on peut utiliser un procédé de double diffusion, mais il est également possible de réaliser à travers un seul masque la diffusion simultanée d'impuretés de nature et de vitesse de diffusion différentes, la diffusion de chacune d'elles étant alors délimitée aux zones devant correspondre aux îlots 3, 10, 12, 13.

Les opérations suivantes, à savoir dépôt d'une couche d'oxyde propre 14 et d'une couche 15 de silicium polycristallin constituant la grille, dépôt d'une nouvelle couche isolante d'oxyde 16, puis dépôt de couches métalliques 17, 18 et 19 respectivement sur la zone de source, sur la région de grille et sur la zone de drain sont réalisées selon des procédés et des moyens classiques. De préférence, le diamètre D du cercle inscrit dans l'élément additionel 8 de forme hexagonale est égal à la distance d séparant deux zones de source contiguës, cette distance d étant maintenue constante sur l'ensemble du dispositif.

Dans une autre forme préférentielle de mise en œuvre, les couches d'oxyde 14 et de silicium polycristallin 15 sont déposées avant la création des divers îlots de types P et N dans la couche 5, et servent alors de masques pour la diffusion desdits îlots.

## Revendications

1. Dispositif de type MOS FET vertical à structure plane multicellulaire réalisé dans un cristal semiconducteur et comportant un ensemble de cellules élémentaires identiques (1) de forme polygonale simple, régulièrement distribuées à la surface du dispositif, cellules élémentaires au centre de chacune desquelles est située une région dite de court-circuit N+/P+ (3), chaque cellule étant constituée, dans une couche (5) d'un premier type de conduction constituant la zone de drain du dispositif,

d'un premier îlot (3, 12) fortement dopé d'impuretés d'un second type de conduction opposé au premier définissant, entre autres, à la surface de ladite couche, le contour de ladite zone de drain et la forme de ladite cellule (1), et, dans ledit premier îlot (3, 12),

d'un second îlot localisé (2) fortement dopé d'impuretés du premier type de conduction constituant la zone de source et qui délimite, d'une part une zone superficielle (4) dite de canal séparant ledit second îlot (2) de la couche (5) du premier type de conduction, et d'autre part la région centrale de court-circuit (3), dispositif caractérisé en ce que les cellules élémentaires sont triangulaires, et que dans le volume des zones de drain laissé libre entre six sommets adjacents appartenant à six cellules élémentaires voisines, sont disposés des éléments additionnels (8) de même structure et de même fonction que lesdites cellules élémentaires (1) et ayant une forme hexagonale.

2. Dispositif selon la revendication 1, caractérisé en ce que les éléments additionnels (8) sont disposés de manière telle que leurs sommets se trouvent en regard des sommets des cellules élémentaires (1).

3. Dispositif selon la revendication 1, caractérisé en ce que les éléments additionnels (8) sont disposés de manière telle que leurs côtés se trouvent en regard des sommets des cellules élémentaires (1).

4. Dispositif selon l'une des revendications 1 à 3, caractérisé en ce que la valeur du diamètre (D) du cercle inscrit dans l'élément additionnel (8) est égale à la distance (d) séparant les zones de source (2) de deux cellules élémentaires contiguës (1).

**Claims**

1. A device of the vertical MOS FET type having a planar multicell structure formed in a semiconductor crystal and comprising an assembly of identical elementary cells (1) of simple polygonal form regularly distributed at the surface of the device, wherein at the centres of each of these elementary cells a so-called $n^+/p^+$ short-circuit region (3) is situated, each cell being formed in a layer 5 of a first conductivity type constituting the drain zone of the device,

a first island (3, 12) strongly doped with impurities of a second conductivity type opposite to the first type defining inter alia at the surface of the said layer the contour of the said drain zone and the form of the said cell (1) and in the said first island (3, 12)

a second local island (2) strongly doped with impurities of the first conductivity type constituting the source zone and limiting on the one hand a superficial so-called channel zone (4) separating the said second island (2) from the layer (5) of the first conductivity type and on the other hand the central shortcircuit region (3), which device is characterized in that the elementary cells are triangular and in that in the volume of the drain zone left free between six adjacent tops belonging to six adjacent elementary cells are disposed additional elements (8) having the same structure and the same function as the said elementary cells (1) and having a hexagonal form.

2. A device as claimed in Claim 1, characterized in that the additionnal elements (8) are disposed in such a manner that their tops are situated opposite to the tops of the elementary cells (1).

3. A device as claimed in Claim 1, characterized in that the additional elements (8) are disposed in such a manner that their sides are situated opposite to the tops of the elementary cells (1).

4. A device as claimed in any one of Claims 1 to 3, characterized in that the value of the diameter D of the circle inscribed in the additional element (8) is equal to the distance d between the source zones (2) of two contiguous elementary cells (1).

**Patentansprüche**

1. Anordnung vom vertikalen MOS-FET-Typ mit einer planaren multizellularen Struktur in einem Halbleiterkristall und mit einer Vielzahl identischer regelmässig über die Oberfläche der Anordnung verteilter Elementarzellen (1) einer einfachen polygonalen Form, wobei in der Mitte jeder der Elementarzellen ein als Kurzschlussgebiet N+P+ (3) bezeichnetes Gebiet liegt, wobei jede Zelle in einer die Drain-Zone der Anordnung bildenden Schicht (5) vom ersten Leitungstyp gebildet wird aus:

einer ersten Insel (3, 12), die mit Verunreinigungen von einem zweiten, dem ersten entgegengesetzten Leitungstyp hochdotiert ist und u.a. auf der Oberfläche der genannten Schicht den Umriss der genannten Drain-Zone und die Form der genannten Zelle (1) definiert und in der ersten Insel (3, 12),

einer zweiten angebrachten Insel (12), die mit Verunreinigungen vom ersten Leitungstyp hochdotiert ist und die Source-Zone bestimmt und die einerseits eine als Kanalzone bezeichnete Oberflächenzone (4) begrenzt, welche die genannte zweite Insel (2) von der Schicht (5) vom ersten Leitungstyp trennt, sowie das zentrale Kurzschlussgebiet (3), dadurch gekennzeichnet, dass die Elementarzellen dreieckig sind und dass in dem Raum der Drain-Zonen zwischen sechs Spitzen von sechs benachbarten Elementarzellen zusätzliche Elemente (8) derselben Struktur und derselben Funktion wie die Elementarzellen (1) und mit einer hexagonalen Form vorgesehen sind.

2. Anordnung nach Anspruch 1, dadurch gekennzeichnet, dass die zusätzlichen Elemente (8) derart angeordnet sind, dass die Spitzen gegenüber den Spitzen der Elementarzellen (1) liegen.

3. Anordnung nach Anspruch 1, dadurch gekennzeichnet, dass die zusätzlichen Elemente (8) derart angeordnet sind, dass ihre Seiten gegenüber den Spitzen der Elementarzellen (1) liegen.

4. Anordnung nach einem der Ansprüche 1 bis 3, dadurch gekennzeichnet, dass der Wert des Durchmessers (D) des Inkreises des zusätzlichen Elementes (8) dem Abstand (d) zwischen den Source-Zonen (2) zweier benachbarter Elementarzellen entspricht.

FIG.1

FIG.2